(19) **Europäisches Patentamt**
**European Patent Office**
**Office européen des brevets**

(11) **EP 2 005 487 B1**

(12) **EUROPEAN PATENT SPECIFICATION**

(45) Date of publication and mention
of the grant of the patent:
**22.06.2011 Bulletin 2011/25**

(51) Int Cl.:
***H01L 31/18*** (2006.01)    ***H01L 23/498*** (2006.01)
***H05K 3/34*** (2006.01)

(21) Application number: **06809889.6**

(22) Date of filing: **21.11.2006**

(86) International application number:
**PCT/IL2006/001340**

(87) International publication number:
**WO 2007/060657 (31.05.2007 Gazette 2007/22)**

(54) **SYSTEM AND METHOD FOR PRODUCING A SOLAR CELL ARRAY**

SYSTEM UND VERFAHREN ZUM HERSTELLEN EINES SOLARZELLEN-ARRAYS

SYSTÈME ET PROCÉDÉ DE PRODUCTION D UNE MATRICE DE CELLULES SOLAIRES

(84) Designated Contracting States:
**AT BE BG CH CY CZ DE DK EE ES FI FR GB GR HU IE IS IT LI LT LU LV MC NL PL PT RO SE SI SK TR**

(30) Priority: **25.11.2005 US 739868 P**

(43) Date of publication of application:
**24.12.2008 Bulletin 2008/52**

(73) Proprietor: **Israel Aerospace Industries Ltd.**
**70100 Lod (IL)**

(72) Inventors:
• **HALFON, Moshe**
**69014 Tel Aviv (IL)**
• **LEIBOVITZ, Jonathan**
**44254 Kfar Saba (IL)**
• **RUZANSKY, Shaya**
**70300 Be'er Yaacov (IL)**
• **SHALOM, Mor**
**73142 Shoham (IL)**
• **STEINMAN, Abraham**
**74065 Nes Ziona (IL)**

(74) Representative: **Schuhmann, Albrecht**
**c/o Merten & Pfeffer**
**Allersberger Strasse 185**
**90461 Nürnberg (DE)**

(56) References cited:
**EP-A- 0 831 533**    **EP-A- 1 298 726**
**US-A- 4 836 861**

Description

## FIELD OF THE DISCLOSED TECHNIQUE

The disclosed technique relates to solar systems in general, and to methods and systems for bonding a plurality of photovoltaic cells to a substrate, in particular.

## BACKGROUND OF THE DISCLOSED TECHNIQUE

Electric power can be generated either from a non-renewable source (e.g., coal, liquid natural gas, crude oil, hydrogen) or a renewable source (e.g., wind, solar, wave, biofuel, hydropower). Electric power from the sun is produced by exposing a solar panel to solar radiation. A solar panel includes a plurality of photovoltaic cells made of a semiconductor which are electrically and mechanically connected to a flat substrate, in an electrical circuit. When photons strike the photovoltaic cells, each of the photovoltaic cells generates electric power. The electric circuit is constructed in such a manner, that the output electric power is maximal.

Each of the photovoltaic cells includes a cell positive terminal and a cell negative terminal. Each of the cell positive terminal and cell negative terminal is produced by coating one of the flat surfaces of the photovoltaic cell with a conductive material (e.g., copper alloy). The electrical circuit includes a plurality of circuit positive terminals and circuit negative terminals. Each of the circuit positive terminals and circuit negative terminals is produced by coating the flat substrate with a conductive material (e.g., copper alloy). Each cell positive terminal is electrically and mechanically connected with a respective circuit positive terminal. Each cell negative terminal is electrically and mechanically connected with a respective circuit negative terminal.

Methods for connecting a cell terminal of the photovoltaic cell with a circuit terminal of the flat substrate, are known in the art. In one case, the connection is provided by an electrically and thermally conductive adhesive. In another case, a solder in form of a thin foil is placed between the cell terminal and the circuit terminal, and heated, in order to fuse the cell terminal with the circuit terminal. In yet another case, the photovoltaic cell is in form of a flip-chip (i.e., surface mounted chip), which includes two solder bumps at a bottom surface thereof. The photovoltaic cell is placed on an appropriate position on top of the circuit terminal, and heat is applied to the solder bumps, the cell terminal and the circuit terminal. This heat melts the solder bumps, thereby electrically and mechanically bonding the photovoltaic cell with the substrate.

The coefficients of thermal expansion of the flip-chip and the substrate are generally different. Therefore, the flip-chip and the substrate shrink or expand differently as the ambient temperature changes, and as a result mechanical stresses are developed at a joint between the flip-chip and the substrate. A material is introduced in a gap between the flip-chip and the substrate, in order to equalize the stress on the joint. Since the underfill material is introduced to the gap by capillary action, the underfill material can contain air pockets. This non-uniform underfill decreases the ability of the underfill material to protect the interconnections between the flip-chip and the substrate, thus causing the reliability of the chip to deteriorate. Methods to produce a uniform underfill material are known in the art. One such method utilizes a vacuum source to draw the underfill material from one end, while the underfill material is introduced from the other end.

The cooler the temperature of the photovoltaic cell during operation, the higher the efficiency thereof, and the greater the electric power which the photovoltaic cell generates. Methods for dissipating the heat generated by the photovoltaic cell and transferring this heat away from the photovoltaic cell, are known in the art. For example, the photovoltaic cell is cooled by providing a thermal path from the photovoltaic cell to the ambient air, having a small resistance. As another example, the substrate on which the photovoltaic cell is mounted, is connected with a cooler from below, to carry away this heat.

US Patent No. 6,906,253 B2 issued to Bauman et al., and entitled "Method for Fabricating a Solar Tile", is directed to a solar tile which includes a flexible circuit and a plurality of solar cells. An adhesive layer is applied to a front insulating sheet of the flexible circuit. The adhesive layer includes a release sheet. A plurality of apertures are created through the front insulating sheet and the adhesive layer, and a plurality of corresponding holes are created through a rear insulating sheet of the flexible circuit. A solder material such as lead, silver or tin, is deposited in each of the apertures and the holes. The release sheet is removed from the adhesive layer, and the solar cells are transferred and secured to the flexible circuit to create a resulting solar circuit. Document EP 1 298 726 A discloses a method to provide a solder composition for semiconductor circuits.

US Patent No. 6,048,656 issued to Akram et al., and entitled "Void-Free Underfill of Surface Mounted Chips" is directed to a method for connecting a flip-chip to a printed circuit board (PCB), by conventional direct chip bonding techniques. Two dams are formed on the PCB around the four walls of the flip-chip. An active surface of the flip-chip includes integrated circuitry and a plurality of contact pads, and corresponding solder bumps. The solder bumps are aligned with the contact pads of the active circuitry of the PCB, and the flip-chip is electrically and mechanically connected to the PCB. The dams help contain the flow of an underfill material from a gap beneath the flip-chip.

The underfill material is applied via an underfill dispenser through an opening at a first corner of the flip-chip. A vacuum cup is placed over an opening at a second corner of the flip-chip, to draw the underfill material into the gap. The vacuum cup is employed to displace air pockets, bubbles, and voids found within the underfill material, by underfill material, as the underfill material flows under the flip-chip.

US Patent No. 6,881,671 B2 issued to Jensen et al., and entitled "Process for Depositing Metal Contacts on a Buried Grid Solar Cell and Solar Cell Obtained by the Process", is directed to a method for applying metal contacts (grooves) to a light incident front surface and to a backside surface of a solar cell, while avoiding voids to form in the grooves, in order to enable photogenerated free electrons to be carried away from the solar metal contacts.

A top surface coating of an electrically insulating layer is provided on the solar cell surface, and the grooves are cut into that surface. A thin layer of seed layer of electroless nickel is applied followed by a sintering process. A thick base layer of nickel is deposited by electroless deposition process, on the top of the seed layer. The grooves are filled by electrolytic copper plating, while avoiding voids to form within the grooves.

US Patent No. 6,121,689 issued to Capote et al., and entitled "Semiconductor Flip-Chip Package and Method for the Fabrication Thereof", is directed to a method for connecting a flip-chip to a substrate. A plurality of solder pads on a top surface of the substrate, are arranged to receive corresponding solder bumps connected to a plurality of contact pads of the flip-chip. The flip-chip is pre-coated with a first portion of an encapsulation material. The substrate is pre-coated with a second portion of the encapsulation material. The flip-chip is oriented at an angle relative to the substrate.

As the first portion is moved into intimate contact with the second portion, the flip-chip is pivoted about a first point of contact, until all of the solder bumps are in contact with the solder pads, and the assembly is heated to cure the encapsulation material. In this manner, any gas that could be entrapped between the first portion and the second portion is expelled, to prevent formation of voids in the encapsulation material.

International Application Publication No. WO 95/24058 to United Solar Systems Corp., and entitled "Large Area, Through-Hole, Parallel-Connected Photovoltaic Device", is directed to a method for manufacturing a photovoltaic device. The photovoltaic device includes a conductive substrate, an electrically insulating coating, a bottom electrode layer, a photovoltaic body, an electrically conductive layer, and a top encapsulant layer. The electrically insulating coating is located on top of the conductive substrate. The bottom electrode is located on top of the electrically insulating coating. The photovoltaic body is located on top of the bottom electrode. The electrically conductive layer is located on top of the photovoltaic body. The top encapsulant layer is located on top of the electically conductive body.

The photovoltaic device includes a plurality of first holes and a plurality of second holes. The diameter of each of the first holes is greater than that of each of the second holes. Each pair of the first holes and the second holes are concentric. Each of the first holes exposes a first edge portion of the bottom electrode layer. Each of the second holes exposes a second edge portion of the electrically insulating coating. The electrically conductive layer fills an unfilled portion of each of the first holes, and at least a portion of the corresponding second hole, and establishes electrical communication with the conductive substrate. The absorption of photons in the photovoltaic body creates a photocurrent which is collected by the bottom electrode layer and the electrically conductive layer.

## SUMMARY OF THE PRESENT DISCLOSED TECHNIQUE

It is an object of the disclosed technique to provide a novel method for soldering at least one substantially large terminal of a high power electrical component to a substantially large area contact surface, and a high power high thermally conductive platform.

In accordance with the disclosed technique, there is thus provided a method for soldering at least one substantially large terminal of a high power electrical component to a substantially large area contact surface. The method comprising the procedures of depositing soldering material on the substantially large area contact surface according to a protruding pattern, placing the at least one substantially large terminal on the deposited soldering material and heating the substantially large terminal, the soldering material and the substantially large area contact surface, according to a predetermined heating profile. The protruding pattern defines a plurality of passages leading toward the perimeter of the substantially large contact surface. The area of the terminal substantially overlaps with a portion of the substantially large area contact surface. The passages provides discharge of gas entrapped between the soldering material and the substantially large terminal, toward the perimeter, to produce a substantially void free solid soldering material.

In accordance with another aspect of the disclosed technique, there is thus provided a high power high thermally conductive platform. The high power high thermally conductive platform comprises a substrate, at least one substantially large area contact surface and a high power electrical component. The substantially large area contact surface is coupled with the substrate. The high power electrical component, includes at least one substantially large area terminal. The substantially large area terminal is soldered to the substantially large area contact surface. The high power electrical component is soldered to the substantially large area contact surface by depositing soldering material on the substantially large area contact surface, by placing the substantially large area terminal on the soldering material and by heating the substantially large area terminal, the soldering material and the substantially large area contact surface, according to a predetermined heating profile. The soldering material is deposited on the substantially large area contact surface according to a protruding pattern. The protruding pattern defines a plurality of passages leading toward a perimeter of the substantially large area contact surface. An area of the at least one substantially large area terminal substantially overlaps with a portion of the substantially large area contact surface. Gas entrapped in the soldering material discharges away from the substantially large area contact surface, through the passages, to produce a substantially void free solid soldering material.

**BRIEF DESCRIPTION OF THE DRAWINGS**

The disclosed technique will be understood and appreciated more fully from the following detailed description taken in conjunction with the drawings in which:

Figure 1A is a schematic illustration of a portion of a solar panel being constructed according to an embodiment of the disclosed technique;

Figure 1B is a schematic illustration of a portion of a solar panel constructed according to another embodiment of the disclosed technique;

Figure 2 is a schematic illustration of a top view of a pattern for depositing a soldering material on a large area contact surface, for soldering the large area contact surface to a large area terminal of a high power electrical component, according to a further embodiment of the disclosed technique;

Figure 3 is a schematic illustration of a top view of a pattern for depositing the soldering material on the large area contact surface of the solar panel of Figure 1A, according to another embodiment of the disclosed technique;

Figure 4 is a schematic illustration of a top view of a pattern for depositing the soldering material on the large area contact surface of the solar panel of Figure 1A, according to a further embodiment of the disclosed technique;

Figure 5 is a schematic illustration of a top view of a pattern for depositing the soldering material on the large area contact surface of the solar panel of Figure 1A, according to another embodiment of the disclosed technique;

Figure 6 is a schematic illustration of a top view of a pattern for depositing the soldering material on the large area contact surface of the solar panel of Figure 1A, according to a further embodiment of the disclosed technique;

Figure 7 is a schematic illustration of a heating profile for heating the soldering material, the large area contact surface and the large area terminal of Figure 1A, operative according to another embodiment of the disclosed technique;

Figure 8A is a schematic illustration of a top view of a portion of a solar panel, constructed and operative according to a further embodiment of the disclosed technique;

Figure 8B is a schematic illustration of a detail view of a corner of the portion of the solar panel of Figure 8A, excluding a flow limiter as illustrated in Figure 8C;

Figure 8C is a schematic illustration of the detail view of Figure 8B, including a flow limiter, and constructed and operative according to another embodiment of the disclosed technique;

Figure 9 is a schematic illustration of a method for soldering a large area terminal of the high power electrical component of Figure 1A, with a portion of a large area contact surface, operative according to a further embodiment of the disclosed technique;

Figure 10A is a schematic illustration of a solar panel constructed and operative in accordance with another embodiment of the disclosed technique;

Figure 10B is a perspective view of the perforated layers of the cooling compartment of Figure 10A;

Figure 10C is a schematic illustration of section I-I of perforated layers of Figure 10B;

Figure 11A is a schematic illustration of a plurality of cells on a cell array, constructed and operative in accordance with a further embodiment of the disclosed technique;

Figure 11B is a schematic illustration of the cells of Figure 11A, coupled with a load in a circuit;

Figure 12 is a schematic illustration of a circuit including a plurality of cells, constructed and operative in accordance with another embodiment of the disclosed technique;

Figure 13 is a schematic illustration of a circuit including three groups, constructed and operative in accordance with a further embodiment of the disclosed technique;

Figure 14A is a schematic illustration of a plurality of cells embedded in a cell array, constructed and operative in accordance with another embodiment of the disclosed technique;

Figure 14B is a schematic illustration of the four quadrants of a circle;

Figure 14C is a schematic illustration of a circuit in which the groups and the sub-groups of Figure 14A are coupled with a load; and

Figure 15 is a schematic illustration of a plurality of groups and sub-groups in a cell array, constructed and operative in accordance with a further embodiment of the disclosed technique.

**DETAILED DESCRIPTION OF THE EMBODIMENTS**

The disclosed technique overcomes the disadvantages of the prior art by depositing a soldering material on a large area contact surface, placing the large area terminals of a high power electrical component on the solder material, and applying heat, to fuse the large area terminals with the large area contact surface. The soldering material is deposited on the large area contact surface, in such a manner that a plurality of passages are formed on the soldering material, wherein each passage leads to the periphery of the large area contact surface. These passages allow the gas which is entrapped in the gap between the solder material and the large area terminal, as well as foreign material which is included in the solder material (e.g., flux), to escape, when heat is applied and the solder material is in a molten state. In this manner, the soldered joint between the large area terminals and the large area contact surface, is free of voids, air bubbles and gases, thereby providing a path between the large area terminals and the large area contact surface, having a low thermal resistance, a high thermal conductivity and a high electrical conductivity.

The term "high power electrical component" herein below, refers to an electrical device which dissipates heat at a large flux, and operate at high electrical currents, such as a photovoltaic cell, an active antenna in form of a plate or a sheet, Microwave Monolithic Integrated Circuit (MMIC), and the like. The terms "large area contact surface", "large area terminal" and various physical properties mentioned herein below, refer to being substantially of such character.

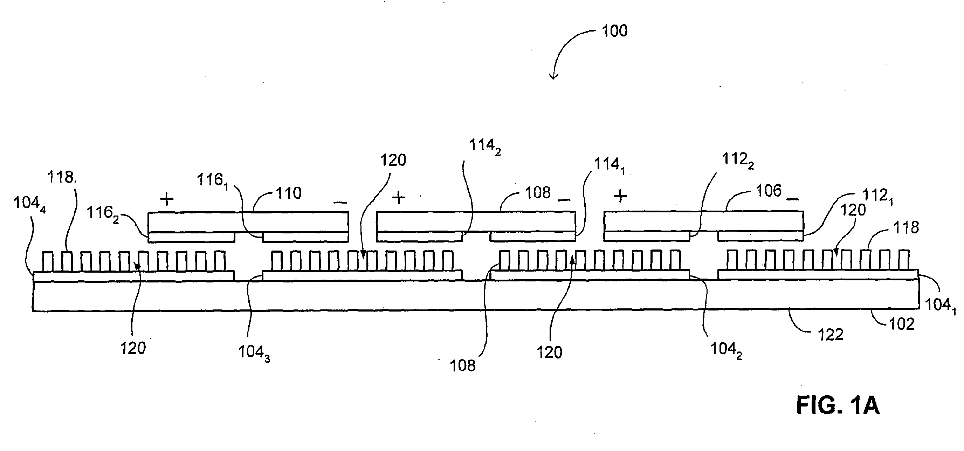

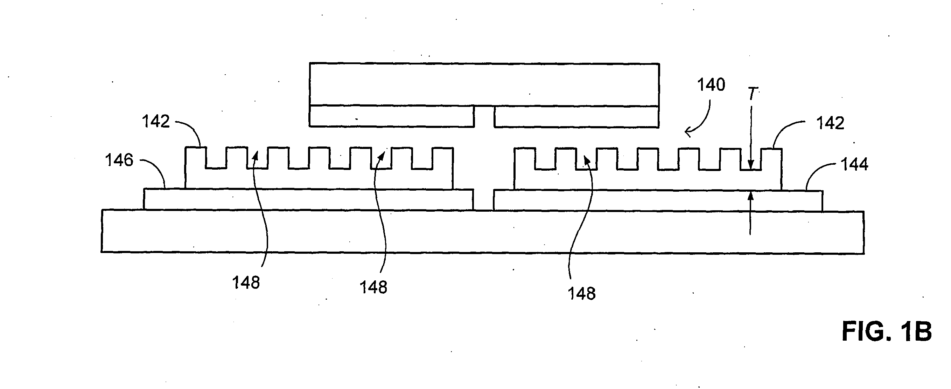

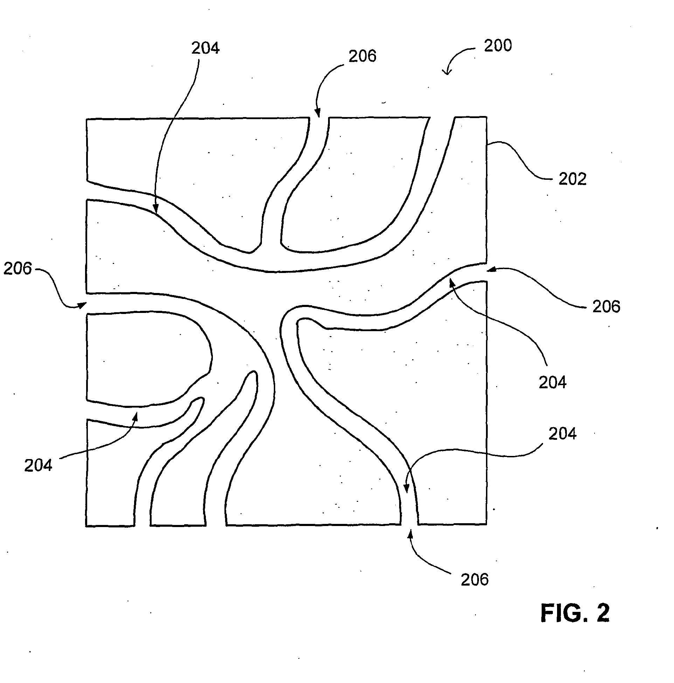

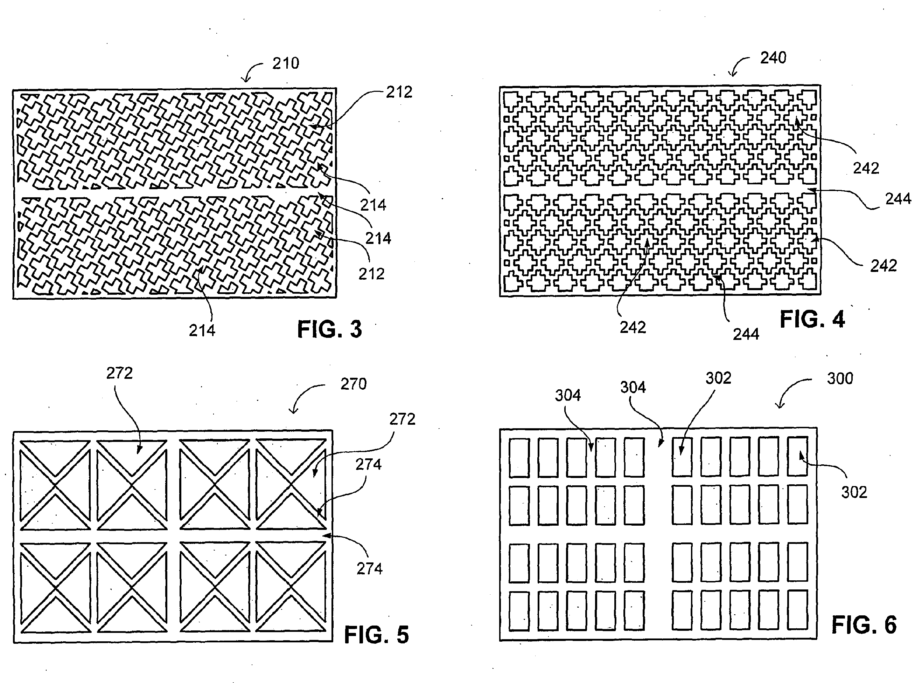

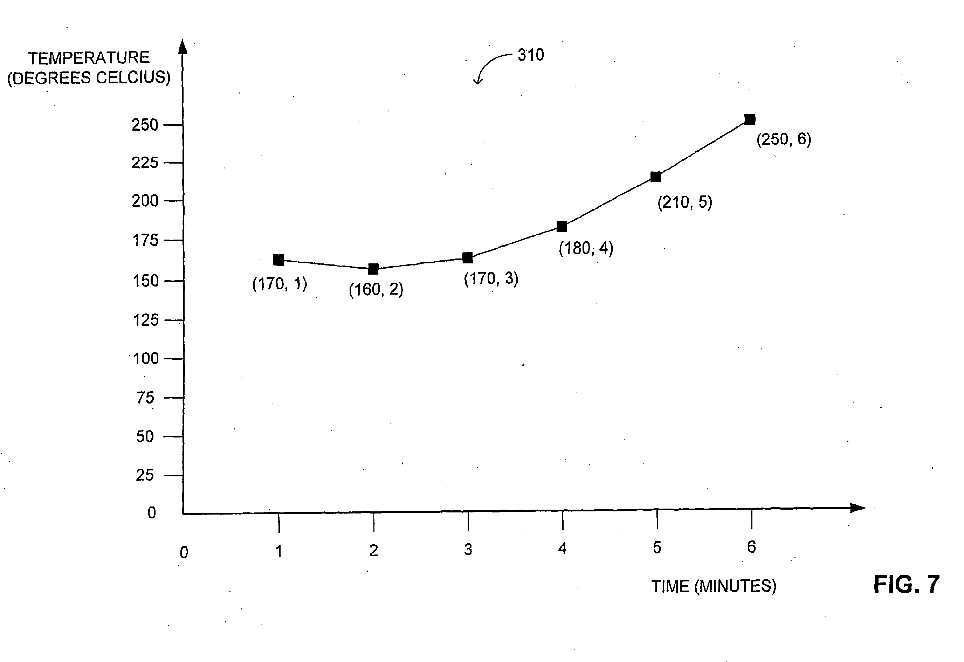

Reference is now made to Figures 1A, 1B, 2, 3, 4, 5, 6, and 7. Figure 1A is a schematic illustration of a portion of a solar panel generally referenced 100, being constructed according to an embodiment of the disclosed technique. Figure 1B is a schematic illustration of a portion of a solar panel generally referenced 140, constructed according to another embodiment of the disclosed technique. Figure 2 is a schematic illustration of a top view of a pattern generally referenced 200, for depositing a soldering material on a large area contact surface, for soldering the large area contact surface to a large area terminal of a high power electrical component, according to a further embodiment of the disclosed technique. Figure 3 is a schematic illustration of a top view of a pattern generally referenced 210, for depositing the soldering material on the large area contact surface of the solar panel of Figure 1A, according to another embodiment of the disclosed technique. Figure 4 is a schematic illustration of a top view of a pattern generally referenced 240, for depositing the soldering material on the large area contact surface of the solar panel of Figure 1A, according to a further embodiment of the disclosed technique. Figure 5 is a schematic illustration of a top view of a pattern generally referenced 270, for depositing the soldering material on the large area contact surface of the solar panel of Figure 1A, according to another embodiment of the disclosed technique. Figure 6 is a schematic illustration of a top view of a pattern generally referenced 300, for depositing the soldering material on the large area contact surface of the solar panel of Figure 1A, according to a further embodiment of the disclosed technique. Figure 7 is a schematic illustration of a heating profile generally referenced 310, for heating the soldering material, the large area contact surface and the large area terminal of Figure 1A, operative according to another embodiment of the disclosed technique.

With reference to Figure 1A, solar panel 100 includes a substrate 102, a plurality of large area contact surfaces $104_1$, $104_2$, $104_3$, and $104_4$, a plurality of high power electrical components 106, 108, and 110, and a plurality of large area terminals $112_1$, $112_2$, $114_1$, $114_2$, $116_1$, and $116_2$; and a soldering material 118. Substrate 102 is made of a material having a large dielectric constant (i.e., electrically insulating), a large coefficient of thermal conductivity, and a high mechanical strength, such as ceramic Alumina ($Al_2O_3$), Aluminum Nitride, Anodized Aluminum, and the like. Each of large area contact surfaces $104_1$, $104_2$, $104_3$, and $104_4$, is in form of a coating applied to substrate 102. These coatings are made of a noble material having a large electrical conductivity, and thermal conductivity, such as gold, copper, and the like.

Each of large area terminals $112_1$, $112_2$, is applied as a coating to the respective pole of high power electrical component 106. Each of large area terminals $114_1$, $114_2$, is applied as a coating to the respective pole of high power electrical component 108. Each of large area terminals $116_1$, $116_2$, is applied as a coating to the respective pole of high power electrical component 110. Soldering material 118 is deposited on each of large area contact surfaces $104_1$, $104_2$, $104_3$, and $104_4$.

Large area terminals $112_2$ and $114_1$ are to be soldered to large area contact surface $104_2$, in order to electrically connect a positive pole of high power electrical component 106, to a negative pole of high power electrical component 108. Large area terminals $114_2$ and $116_1$ are to be soldered to large area contact surface $104_3$, in order to electrically connect a positive pole of high power electrical component 108, to a negative pole of high power electrical component 110. According to the same principle, large area terminal $112_1$ is to be soldered to large area contact surface $104_1$, and large area terminal $116_2$ is to be soldered to large area contact surface $104_4$. This soldering procedure is performed according to methods known in the art (e.g., heating in a furnace, applying electromagnetic radiation).

In order to perform the soldering procedure, soldering material 118 is deposited on each of large area contact surfaces $104_1$, $104_2$, $104_3$, and $104_4$, in such a manner that a plurality of passages 120 are formed in a protruding pattern of soldering material 118. Each of passages 120 leads toward the perimeter of each of large area contact surfaces $104_1$, $104_2$, $104_3$, and $104_4$. Passages 120 allow the gases which are entrapped between a large area contact surface and a large area terminal, to escape, when soldering material 118 is heated and melted. In this manner, at the end of the soldering process, the solder joint (not shown) between a large area terminal and a portion of a large area contact surface, is free of voids, air bubbles and gases. Thus, a highly conductive thermal path from each of high power electrical components 106, 108, and 110, to substrate 102 is provided, to keep each of high power electrical components 106, 108, and 110, at a low operating temperature. Applying the disclosed technique for example, to a photovoltaic cell, enables the photovoltaic cell to operate at a high efficiency and produce a larger electrical power, than if the photovoltaic cell operated at a higher temperature.

Applicant found out that in order to achieve a solid, void free solder joint, soldering material 118, large area contact surfaces $104_1$, $104_2$, $104_3$, and $104_4$, and large area terminals $112_1$, $112_2$, $114_1$, $114_2$, $116_1$, and $116_2$, have to be heated for certain periods of times, at certain temperatures. In case solar panel 100 is manufactured automatically, different regions of a conveyer (not shown) on which the parts of solar panel 100 travel, are kept at selected temperatures, by applying heat from below and above. The temperature of each region depends on physical characteristics of each of large area contact surfaces $104_1$, $104_2$, $104_3$, and $104_4$, large area terminals $112_1$, $112_2$, $114_1$, $114_2$, $116_1$, and $116_2$ and substrate 102 (e.g., area, thickness, material), the type of solder material 118, the conveyor speed, and the like. Applicant found out that applying heat according to heating profile 310 (Figure 7), provides a solid void free solder joint, for a given set of parameters. However, other heating profiles can be employed to suite other parameters. A heating profile can be determined for example, by trial and error, in order to produce a void free solder joint.

Soldering material 118 is in form of a solder paste known in the art. Soldering material 118 can be deposited on each of large area contact surfaces $104_1$, $104_2$, $104_3$, and $104_4$, by different methods, in order to produce a protruding pattern defined by a plurality of passages 120 between a plurality of solder protrusions (e.g., passages 214 between solder protrusions 212, as illustrated in Figure 3).

With reference to Figure 3, protruding pattern 210 includes a plurality of solder protrusions 212, with a plurality of passages 214 there between. With reference to Figure 4, protruding pattern 240 includes a plurality of solder protrusions 242, with a plurality of passages 244 there between. With reference to Figure 5, protruding pattern 270 includes a plurality of solder protrusions 272, with a plurality of passages 274 there between. With reference to Figure 6, protruding pattern 300 includes a plurality of solder protrusions 302, with a plurality of passages 304 there between.

Each of solder protrusions 212, 242, 272, and 302, can be deposited on a large area contact surfaces, for example, by employing a solder paste stencil (not shown). This solder paste stencil is made of a sheet metal, plastic sheet, and the like. The solder paste stencil includes a plurality of holes in the form of each of the solder protrusions which are to be deposited on the large area contact surface. The thickness of the solder paste stencil is equal to the height (not shown) of each of the solder protrusions. The solder paste stencil is placed on the large area contact surface, and the solder paste is spread on the solder paste stencil, in order to pass through the holes to the surface of the large area contact surface.

When the solder paste stencil is removed, some of the solder paste remains on the large area contact surface, in the form of a plurality of solder protrusions, in a negative pattern of the solder paste stencil. The height of each of the solder protrusions is equal to the thickness of the solder paste stencil, and the passages are defined by the distance between the holes in the solder paste stencil. Alternatively, the solder protrusions can be deposited on the large area contact surface, by employing a plurality of paste dispensers, for example, in the form of syringes (i.e., injectors - not shown), each of which deposits a respective solder protrusion of a selected height, on the large area contact surface.

Applicant has found out that if the soldering material is deposited on the large area contact surface according to a protruding pattern 210 (Figure 3), the soldered joint (not shown) is most uniform, and free of voids. However, protruding patterns 240 (Figure 4), 270 (Figure 5), and 300 (Figure 6), also yield soldered joints free of voids.

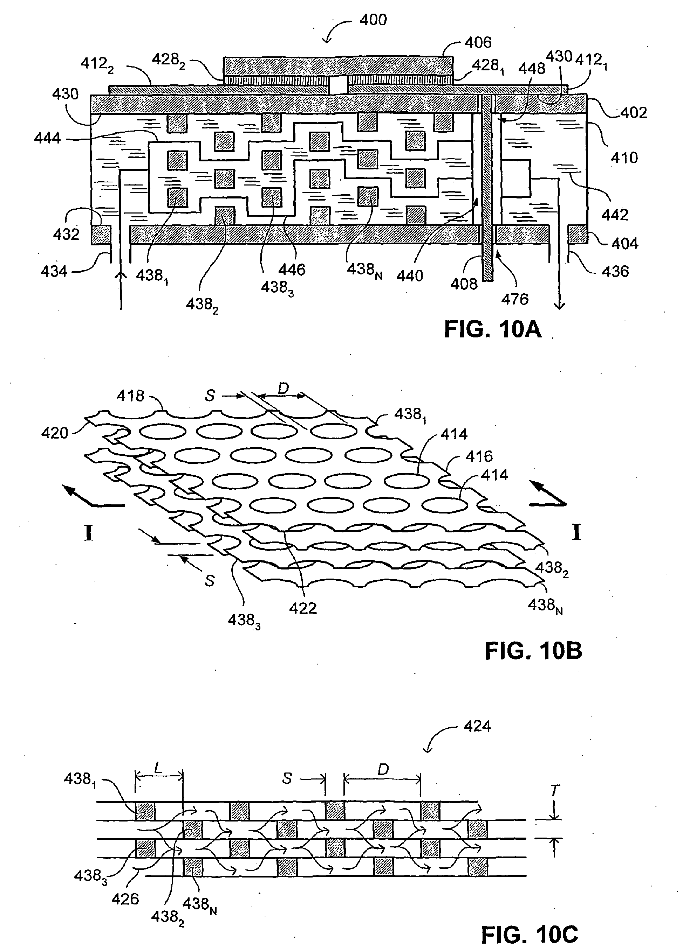

A bottom portion 122 of substrate 102 is coupled with a cooling compartment as described herein below in connection with Figures 10A, 10B, and 10C. The cooling compartment carries away the heat generated by a high power electrical component, thereby maintaining the operation temperature of the high power electrical component at a low level.

With reference to Figure 1B, soldering material 142 covers the entire surface of a first large area contact surface 144 and a second large area contact surface 146. However, soldering material 142 is deposited on each of large area contact surfaces 144 and 146, in such a manner that a plurality of passages 148 in the form of grooves, are formed on the surface of soldering material 142, each of passages 148 leading toward the perimeter of each of large area contact surfaces 144 and 146. It is noted with reference to Figure 1A, that the thickness of the soldering material within each of passages 120 is zero, whereas a thickness $T$ of the soldering material within each of passages 148 is greater than zero.

With reference to Figure 2, soldering material 202 is deposited on a large area contact surface (not shown), in such a manner that a plurality of passages 204 in a random fashion, are formed on the surface of soldering material 202. Each of passages 204 leads toward a perimeter 206 of the large area contact surface, thereby allowing the entrapped gases to escape during the soldering operation.

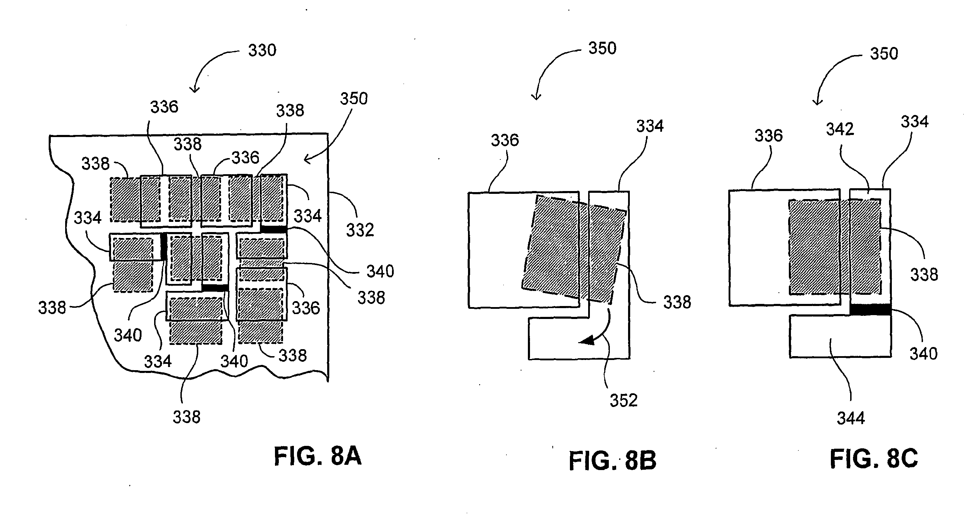

Reference is now made to Figures 8A, 8B, and 8C. Figure 8A is a schematic illustration of a top view of a portion of a solar panel, generally referenced 330, constructed and operative according to a further embodiment of the disclosed technique. Figure 8B is a schematic illustration of a detail view of a corner of the portion of the solar panel of Figure 8A, generally referenced 350, excluding a flow limiter as illustrated in Figure 8C. Figure 8C is a schematic illustration of the detail view of Figure 8B, including a flow limiter, and constructed and operative according to another embodiment of the disclosed technique.

With reference to Figure 8A, solar panel 330 includes a substrate 332, a plurality of large area contact surfaces 334, a plurality of large area contact surfaces 336, a plurality of high power electrical components 338, and a plurality of flow limiters 340. Large area contact surfaces 334 and 336 are coated on substrate 332, as described herein above in connection with Figure 1A. Each of large area contact surfaces 334 is in form of the letter "L". Each of large area contact surfaces 336 is in form of a square.

Each of high power electrical components 338 is coated on a bottom surface thereof (not shown), with two large area terminals (not shown), corresponding to the two poles of the high power electrical component 338. Each of the large area terminals are soldered to a portion of respective one of large area contact surfaces 334 and 336. In this manner, high power electrical components 338 are coupled together in a predetermined electrical circuit.

Each of flow limiters 340 is made of a material whose surface tension energy (i.e., activation energy), is lower than that of a soldering material (not shown) in molten state, which is employed to solder a large area terminal of a high power electrical component, to a respective one of the large area contact surfaces 334 and 336. Flow limiter 340 is made of a material on which the soldering material in the molten state, can not flow nor spread. Hence, flow limiter 340 can be made of self-adhesive thin sheet of a polymeric material. In this manner, flow limiter 340 can be adhered to each of large area contact surfaces 334, as described herein below in connection with Figure 8C. Alternatively, flow limiter 340 can be made of a viscous adhesive (e.g., epoxy), which is applied to large area contact surfaces 334, and cured to a solid state.

With reference to Figure 8B, the soldering material is deposited on large area contact surfaces 334 and 336. The term "soldering system" herein below, refers to a system which includes a respective one of large area contact surfaces 334 and 336, the soldering material, the air, and the flux which is included in the soldering material. The flux precipitates from the soldering material when the soldering material melts, and the flux covers the surface of the molten soldering material. In this manner, the flux reduces the rate of oxidation of the soldering material.

The soldering system, as well as each component of the system (i.e., soldering material, large area contact surface, and the air) possesses a certain activation energy (i.e., surface tension energy) at any given state (e.g., temperature). The activation energy is a local property of the system and it is independent of other portions of the system. The activation energy of the system tends to a minimum value at all times. The activation energy of the soldering material in molten state is lower than that of the large area contact surface. Therefore, when the system is heated and the soldering material melts, the total activation energy of the system drops. This drop in the activation energy causes the soldering material to spread and flow on the surface of the large area contact surface, provided the flux arrests the oxidation of the soldering material rapidly enough.

In order to solder high power electrical component 338 to large area contact surfaces 334 and 336, one large area terminal of high power electrical component 338 is placed on a portion of large area contact surface 334 and the other large area terminal thereof, on another portion of large area contact surface 336. The drop in activation energy of the system, causes the molten soldering material to flow toward the edges of each of large area contact surfaces 334 and 336, and to cover the entire surface of each of large area contact surfaces 334 and 336. The molten soldering material can flow on the surface of large area contact surface 334, for example, in a direction designated by an arrow 352. This direction depends on different parameters, such as the roughness of the surface of large area contact surface 334, the properties of the flux, and the like.

When the soldering material is in the molten state, high power electrical component 338 floats on the molten soldering material, and the flow of the molten soldering material in direction 352, rotates high power electrical component 338 in direction 352. Hence, when the soldering material solidifies, high power electrical component 338 couples with large area contact surfaces 334 and 336 in an oblique orientation relative to that of large area contact surfaces 334 and 336. This oblique orientation can cause an electrical short in the circuit of the solar panel, and malfunctioning of the solar panel.

The soldering material flows on the surface of large area contact surface 336, too. The geometry of large area contact surface 336 is uniform (i.e., a square). Therefore, the vectorial sum of the directions of flow of the molten soldering material on large area contact surface 336 is zero, and the flow of the soldering material on large area contact surface 336 has almost no affect on the movement of high power electrical component 338. However, since the molten soldering material flows in a given direction on large area contact surface 334, this flow develops a force on high power electrical component 338, which tends to pull high power electrical component 338 in direction 352.

With reference to Figure 8C, flow limiter 340 is adhered to large area contact surface 334, at the boundary of two rectangles 342 and 344. Flow limiter 340 prevents the molten soldering material to flow between rectangles 342 and 344, and thus the flow of the molten soldering material is restricted within each of rectangles 342 and 344, only, and not between rectangles 342 and 344. The geometry of rectangle 342 is uniform. Therefore, the vectorial sum of the directions of flow of the molten soldering material on the surface of rectangle 342 is zero, and the net force which acts under high power electrical component 338 is zero. Thus, when the soldering material solidifies, high power electrical component 338 is soldered to large area contact surfaces 334 and 336, in an orientation in line with large area contact surfaces 334 and 336, thereby preventing short circuits.

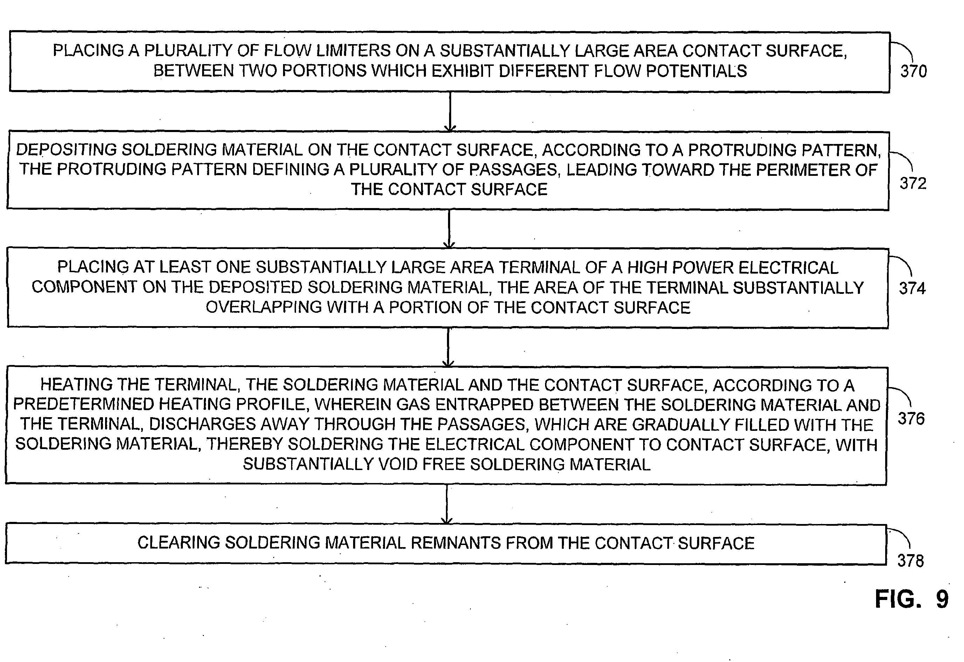

Reference is now made to Figure 9, which is a schematic illustration of a method for soldering a large area terminal of the high power electrical component of Figure 1A, with a portion of a large area contact surface, operative according to a further embodiment of the disclosed technique. In procedure 370, a plurality of flow limiters are placed on a substantially large area contact surface, between two portions which exhibit different flow potentials. With reference to Figure 8, flow limiter 338 is placed between portions 340 and 342 of large area contact surface $336_2$.

In procedure 372, soldering material is deposited on the contact surface according to a protruding pattern, the protruding pattern defining a plurality of passages leading toward the perimeter of the contact surface. With reference to Figure 1A, soldering material 102 is deposited on large area contact surface 104, according to protruding pattern 300 (Figure 6). Protruding pattern 300 defines passages 304 between solder protrusions 302.

In procedure 374, at least one substantially large area terminal of a high power electrical component is placed on the deposited soldering material, the area of the terminal substantially overlapping with one of the portions of the contact surface. With reference to Figures 1A, large area terminal 116 of high power electrical component 114 is placed on soldering material 102. The surface area of large area terminal 116 overlaps with portion 104 of large area contact surface 106.

In procedure 376, the terminal, the soldering material and the contact surface are heated, according to a predetermined heating profile, wherein gas entrapped between the soldering material and the terminal discharges away through the passages which are gradually filled with the soldering material, thereby soldering the electrical component to contact surface with substantially void free soldering material. With reference to Figure 1A, first large area terminal 116, soldering material 102 and large area contact surface 106 are heated, for example, according to selected heating profile, such as heating profile 310 (Figure 7). During this heating process, the gas which is entrapped within soldering material 102 discharges away through passages 120, toward the perimeter of large area contact surface 106. Passages 120 are gradually filled with soldering material 102. As a result, high power electrical component 114 is soldered to large area contact surface 106 with soldering material 102, which is free of voids and air bubbles. There after, the remnants of soldering material 102 are cleared away from large area contact surface 106, by employing a degreasing solution known in the art (procedure 378).

Reference is now made to Figures 10A, 10B and 10C. Figure 10A is a schematic illustration of a solar panel, generally referenced 400, constructed and operative in accordance with another embodiment of the disclosed technique. Figure 10B is a perspective view of the perforated layers of the cooling compartment of Figure 10A. Figure 10C is a schematic illustration of section I-I of perforated layers of Figure 10B.

With reference to Figure 10A, solar panel 400 includes substrates 402 and 404, a plurality of high power electrical components 406, a plurality of pins 408, and a cooling compartment 410. In the following description the term "high power electrical component" and the term "pin" is referred to in singular. Substrate 402 is coated with large area contact surfaces $412_1$ and $412_2$, as described herein above in connection with Figure 1A. A bottom surface (not shown) of high power electrical component 406 is coated with large area terminals $428_1$ and $428_2$ as described herein above in connection with Figure 1A. High power electrical component 406 is soldered to substrate 402, as described herein above in connection with Figure 9.

Each of substrates 402 and 404 is made of Alumina ($Al_2O_3$), Aluminum Nitride, and the like. Pin 408 is made of a material having a large electrical conductivity, such as copper, and the like. Substrate 402 is coupled with a top surface 430 of cooling compartment 410. Substrate 404 is coupled with a bottom surface 432 of cooling compartment 410. Pin 408 is coupled with large area contact surface $412_1$.

Cooling compartment 410 includes an inlet 434 at bottom surface 432, an outlet 436 at bottom surface 432, a plurality of perforated layers $438_1$, $438_2$, $438_3$ and $438_N$, and a plurality of openings 440. The heat generated by high power electrical component 406, transfers to perforated layers $438_1$, $438_2$, $438_3$ and $438_N$ via substrate 402. A cooling fluid 442 such as water, an organic fluid (e.g., a hydrocarbon), and the like, enters cooling compartment 410 through inlet 434. Perforated layers $438_1$, $438_2$, $438_3$ and $438_N$ are arranged in a plurality of layers, to provide a plurality of fluid paths 444 and 446. Cooling fluid 442 flows in fluid paths 444 and 446, around openings 440, cooling fluid 442 absorbs the heat which is generated by high power electrical component 406, and leaves cooling compartment 410 through outlet 436. In this manner, cooling compartment 410 cools high power electrical component 406, thereby enabling efficient operation of high power electrical component 406 (in case of a photovoltaic cell, increasing the output power of the photovoltaic cell).

Substrate 404 serves purpose of balancing the thermal load of solar panel 400, in order to prevent mechanical distortions. However, solar panel 400 can operate also without substrate 404. Alternatively, a plurality of high power electrical components (not shown), can be coupled with substrate 404. In this case, cooling compartment 410 carries away the heat dissipated by high power electrical components 406, as well as those which are coupled with substrate 404. It is noted, that instead of two solar panels on opposite sides of the cooling compartment, other heat generating panels can be coupled with the cooling compartment, such as those which include an active antenna, an MMIC, and the like.

Pin 408 can be coupled with large area contact surface $412_1$, and substrates 402 and 404 can be coupled with top surface 430 and bottom surface 432, respectively, of cooling compartment 410, for example, in a single operation of applying pressure to top surface 430 and bottom surface 432, while subjecting solar panel 400 to high temperatures. In this operation, a hole 448 is drilled in substrate 402 and a hole 476 is drilled in substrate 404.

A diameter of each of holes 448 and 476 is slightly large than a diameter of pin 408, in order to prevent mechanical stresses to be developed in substrates 402 and 404, due to the difference in the thermal coefficient of expansion of substrates 402 and 404 on one hand, and that of pin 408 on the other hand. A diameter of opening 440 is larger than that of pin 408, in order to allow pin 408 to pass through opening 440, without making electrical contact with inside walls (not shown) of opening 440. Pin 408 is coupled with large area contact surface $412_1$, by an adhesive such as copper oxide, by a brazing procedure, and the like. In the case of copper oxide, the temperature level is such that the adhesive melts, while each of pin 408 and large area contact surface $412_1$ remain in the solid state, thereby coupling pin 408 with large area contact surface $412_1$. Pin 408 passes through holes 446 and 476, and through opening 440, to be coupled with an electric module which receives the electrical power generated by solar panel 400, such as a voltage regulator, electric motor, and the like.

With reference to Figure 10B, the construction and arrangement of perforated layers $438_1$, $438_2$, $438_3$ and $438_N$ is described herein below. The boundary of each of perforated layers $438_1$, $438_2$, $438_3$ and $438_N$ is defined by a square, rectangle, circle, ellipse, closed curvature, and the like. Each of perforated layers $438_1$, $438_2$, $438_3$ and $438_N$ is made of a material having a substantially high thermal conductivity, such as copper, copper alloy, aluminum, aluminum alloy, and the like.

Each of perforated layers $438_1$, $438_2$, $438_3$ and $438_N$ includes a plurality of perforations 414. The boundary of each of the perforated layers $438_1$, $438_2$, $438_3$ and $438_N$ is designated by edges 416, 418, 420 and 422. The geometry and dimensions of perforations 414 are substantially identical in all of the perforated layers $438_1$, $438_2$, $438_3$ and $438_N$. Perforations 414 illustrated in Figure 10B have a circular geometry. The diameter of each of the perforations 414 is designated by $D$ and the distance between every two adjoining perforations 414 is designated by $S$, such that $S < D$. Each of the edges 416, 418, 420 and 422 is perforated by perforations 414. It is noted that perforations 414 can have a geometry other than circular, such as a polygon, a closed curvature, and the like.

With reference to Figure 10C, the thickness of each of the perforated layers $438_1$, $438_2$, $438_3$ and $438_N$ is designated by $T$, such that $T << D$. The thickness $T$ is generally of the order of tenths of a millimeter. Perforated layers $438_1$, $438_2$, $438_3$ and $438_N$ are arranged in a stack 424, such that every second of the perforated layers $438_1$, $438_2$, $438_3$ and $438_N$ is offset by a distance $L$, wherein

$$L > S \qquad\qquad (1)$$

$$L \neq D \qquad\qquad (2)$$

By stacking perforated layers $438_1$, $438_2$, $438_3$ and $438_N$ in this manner, a plurality of fluid paths 426 are created between all of the perforated layers $438_1$, $438_2$, $438_3$ and $438_N$. It is noted that stack 424 provides a substantially large contact area with the cooling fluid, thereby increasing the capacity of the cooling fluid to absorb the heat from stack 424.

In the description herein below, the term "cell" refers to a photovoltaic cell (i.e., a high power electrical component), and the term "cell array" refers to an array of photovoltaic cells.

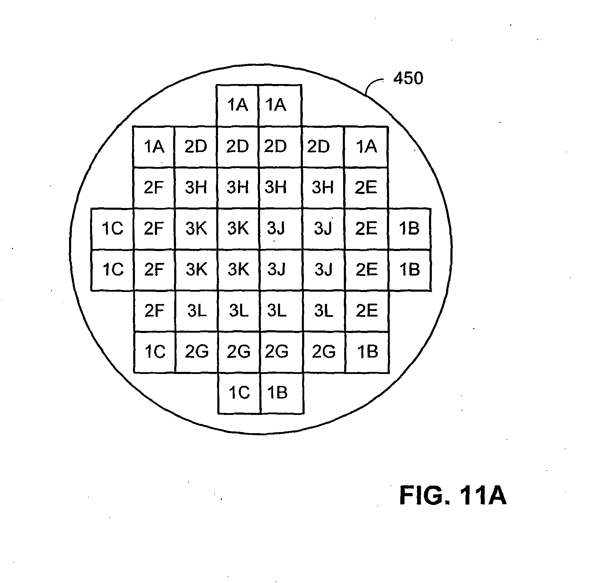

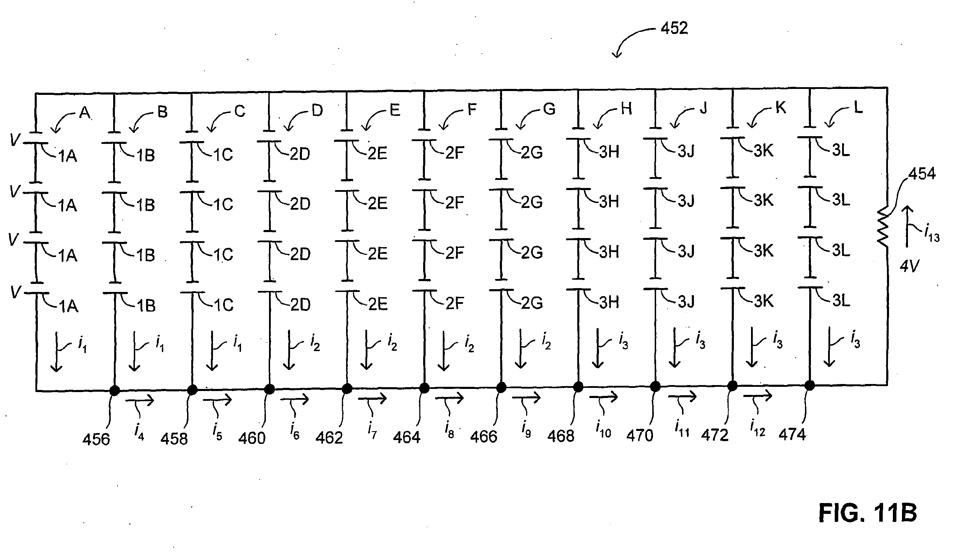

Reference is now made to Figures 11A and 11B. Figure 11A is a schematic illustration of a plurality of cells on a cell array, generally referenced 450, constructed and operative in accordance with a further embodiment of the disclosed technique. Figure 11B is a schematic illustration of the cells of Figure 11A, coupled with a load, in a circuit generally referenced 452.

With reference to Figure 11A, cell array 450 includes four cells designated 1 A, four cells designated 1B, four cells designated 1C, four cells designated 2D, four cells designated 2E, four cells designated 2F, four cells designated 2G, four cells designated 3H, four cells designated 3J, four cells designated 3K and four cells designated 3L. The numeral in each reference, designates the flux of light which reaches the cell and the letter designates the group to which the cell belongs.

For example, 1B indicates that this cell belongs to group B and the light which illuminates this cell, has a flux of for example, 500 kW/m². Cell 1C also receives light with flux of 500 kW/m², but it belongs to group C. Group A includes four cells, each designated 1A, group B includes four cells, each designated 1 B and group C includes four cells, each designated 1C.

The voltage generated by each cell depends on the material structure of the cell (i.e., the energy-gap). Since all cells of cell array 450 are constructed of the same material and the wavelength of the light is uniform throughout, all cells generate substantially the same voltage $V$ (Figure 11 B). The current across a cell is a function of the flux of the light which reaches the cell. Therefore, the cells whose numeral designations are the same (i.e., the cells which receive light of the same flux), produce the same current.

For example, each of the four cells 1A, each of the four cells 1B and each of the four cells 1C, produces the same current $i_1$, because each of these cells receives light with the same flux of 500 kW/m$^2$ (as indicated by the numeral "1"). Each of the four cells 2D, each of the four cells 2E, each of the four cells 2F and each of the four cells 2G, produces the same current $i_2$. Each of the four cells 3H, each of the four cells 3J, each of the four cells 3K and each of the four cells 3L, produces the same current $i_3$.

With reference to Figure 11B, the cells in each group are coupled together in series. For example, the four cells 2D of group D, are coupled together in series. The groups are coupled in parallel to a load 454. For example, the four serially coupled cells 1B, are coupled in parallel to the four serially coupled cells 2F and to load 454. Groups A, B, C, D, E, F, G, H, J, K and L are coupled in parallel to load 454, at nodes 456, 458, 460, 462, 464, 466, 468, 470, 472 and 474. These nodes are all the same node, because they all meet at the same junction. However, each of the nodes 456, 458, 460, 462, 464, 466, 468, 470, 472 and 474 is designated as such, in order to describe the current flows in circuit 452.

According to Kirchhoff's current law, the algebraic sum of the currents into a node at any instant, is equal to zero. Since the four cells 1A are coupled in series and the four cells 1 B are coupled in series, a current $i_1$ flows from group A to node 456 and a current $i_1$ flows from group B to node 456. Thus, at node 456,

$$i_1 + i_1 - i_4 = 0 \qquad\qquad (3)$$

hence,

$$i_4 = 2i_1 \qquad\qquad (4)$$

Group C produces a current $i_1$. Therefore, at node 458,

$$i_5 = i_1 + i_4 \qquad\qquad (5)$$

Combining Equations (4) and (5), yields

$$i_5 = 3i_1 \qquad\qquad (6)$$

Each of the groups D, E, F and G produces a current $i_2$. Each of groups H, J, K and L produces a current $i_3$. Therefore, at each of the nodes 460, 462, 464, 466, 468, 470, 472 and 474, respectively, the following relations hold:

$$i_6 = 3i_1 + i_2 \qquad\qquad (7)$$

$$i_7 = 3i_1 + 2i_2 \qquad\qquad (8)$$

$$i_8 = 3i_1 + 3i_2 \qquad\qquad (9)$$

$$i_9 = 3i_1 + 4i_2 \qquad (10)$$

$$i_{10} = 3i_1 + 4i_2 + i_3 \qquad (11)$$

$$i_{11} = 3i_1 + 4i_2 + 2i_3 \qquad (12)$$

$$i_{12} = 3i_1 + 4i_2 + 3i_3 \qquad (13)$$

and the current flowing through load 454 is,

$$i_{13} = 3i_1 + 4i_2 + 4i_3 \qquad (14)$$

Since the cells in a group are coupled in series, the voltage generated by each group is equal to the sum of the voltages generated by each cell. Each cell produces a voltage $V$. Hence, each group produces a voltage $4V$. Since the groups are coupled in parallel to load 454, the voltage across load 454 is $4V$. The power output of the cells of cell array 450, as coupled together in circuit 452 is

$$P = 4i_{13} \qquad (15)$$

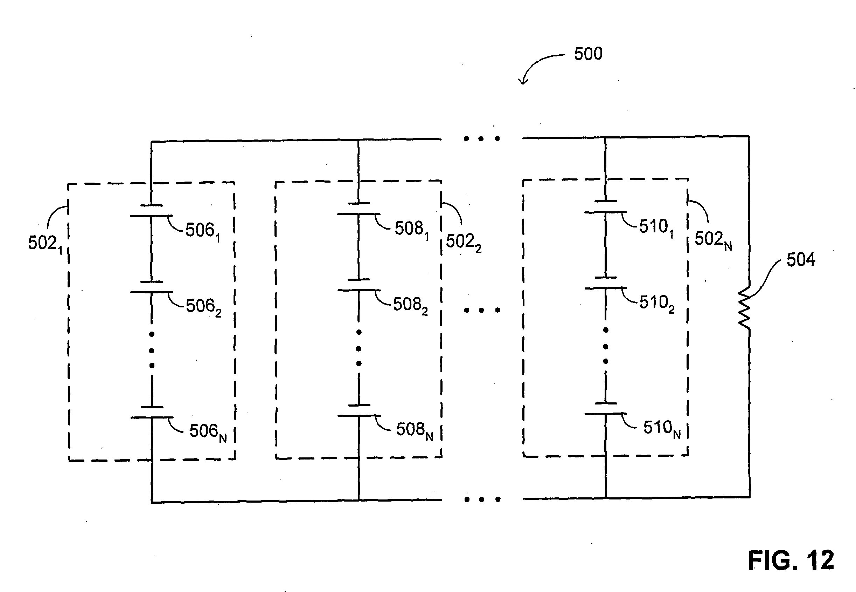

Reference is now made to Figure 12, which is a schematic illustration of a circuit including a plurality of cells, generally referenced 500, constructed and operative in accordance with another embodiment of the disclosed technique. Circuit 500 includes a plurality of groups $502_1$, $502_2$ and $502_N$. Groups $502_1$, $502_2$ and $502_N$ are coupled in parallel to a load 504. Group $502_1$ includes a plurality of cells $506_1$, $506_2$ and $506_N$ coupled together in series. Group $502_2$ includes a plurality of cells $508_1$, $508_2$ and $508_N$ coupled together in series. Group $502_N$ includes a plurality of cells $510_1$, $510_2$ and $510_N$ coupled together in series.

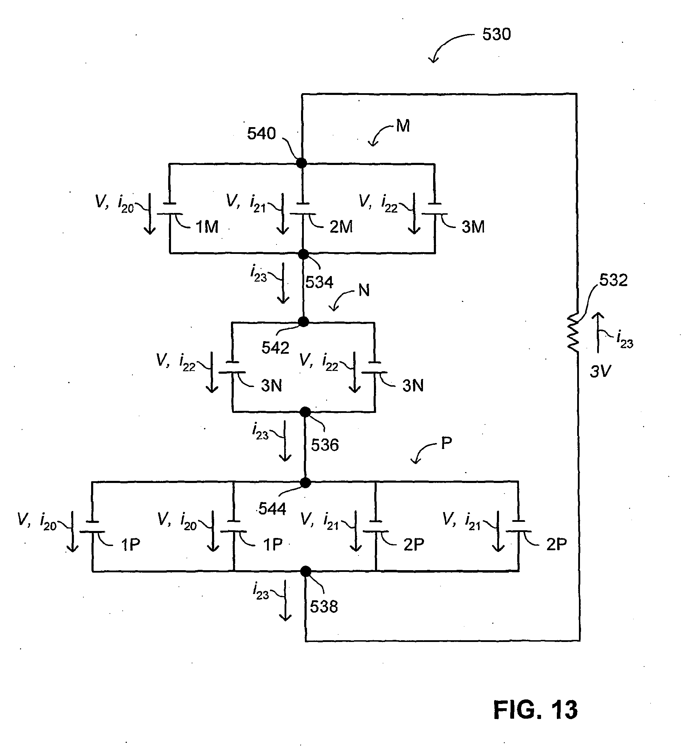

Reference is now made to Figure 13, which is a schematic illustration of a circuit including three groups, generally referenced 530, constructed and operative in accordance with a further embodiment of the disclosed technique. Circuit 530 includes groups M, N and P. Group M includes cells 1 M, 2M and 3M. Group N includes two cells 3N. Group P includes two cells 1 P and two cells 2P.

Groups M, N and P are coupled in series to a load 532. Cells 1M, 2M and 3M of group M are coupled together in parallel. The two cells 3N of group N are coupled together in parallel. The two cells 1 P and the two cells 2P are coupled together in parallel.

Since cells 1 M and 1 P carry the same numeral "1", the light which reaches each of the cells 1 M and 1 P has the same flux, and hence each of the cells 1 M and 1 P produces the same current $i_{20}$. Similarly, each of the cells 2M and 2P produces the same current $i_{21}$, and each of the cells 3M and 3N produces the same current $i_{21}$. Cells 1M, 2M, 3M, the two cells 3N, the two cells 1P and the two cells 2P, are arranged in groups M, N and P, respectively, such that the sum of currents produced by the cells in one group, is equal to the sum of currents produced by the cells in another group.

Thus, applying Kirchhoffs current law to nodes 534, 536 and 538, yields the following relation:

$$i_{20} + i_{21} + i_{22} = 2i_{22} = 2i_{20} + 2i_{21} = i_{23} \qquad (16)$$

For example, if $i_{20}$ = 100 mA, $i_{21}$ = 200 mA and $i_{22}$ = 300 mA, then $i_{20}$ + $i_{21}$ + $i_{22}$ = 600 mA, $2i_{22}$ = 600 mA, $2i_{20}$ + $2i_{21}$ = 600 mA and thus, $i_{23}$ = 600 mA. According to this arrangement of cells into groups, all the groups produce the same current and therefore, the current flowing through load 532 is not restricted to the lowest current produced by a low-current-producing group in circuit 530.

The light which reaches each of the cells 1M, 2M, 3M, the two cells 3N, the two cells 1 P and the two cells 2P, is of the same wavelength. Therefore, each of the cells 1M, 2M, 3M, the two cells 3N, the two cells 1P and the two cells 2P, produces the same voltage $V$. Since the cells in each of the groups M, N and P are coupled together in parallel, the voltage across each pair of the nodes 540 and 534, 542 and 536, and 194 and 538, is $V$. Since the groups M, N and P are coupled in series to load 532, the voltage across load 532 is $3V$.

$$P = 3i_{23} \qquad\qquad (17)$$

It is noted that the number of groups in circuit 530 is not restricted to three and that any number of groups such as groups M, N and P, can be coupled in series to a load.

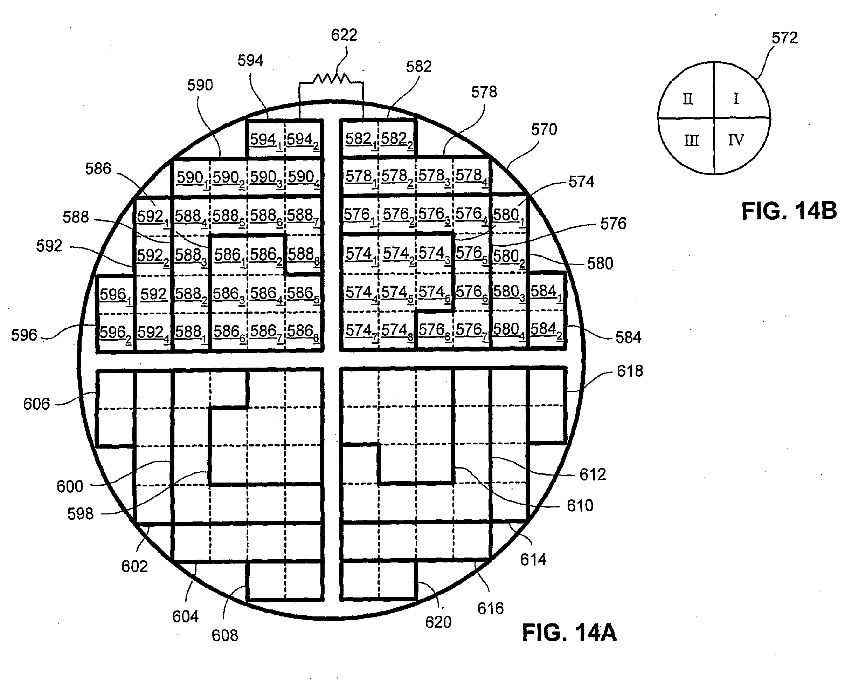

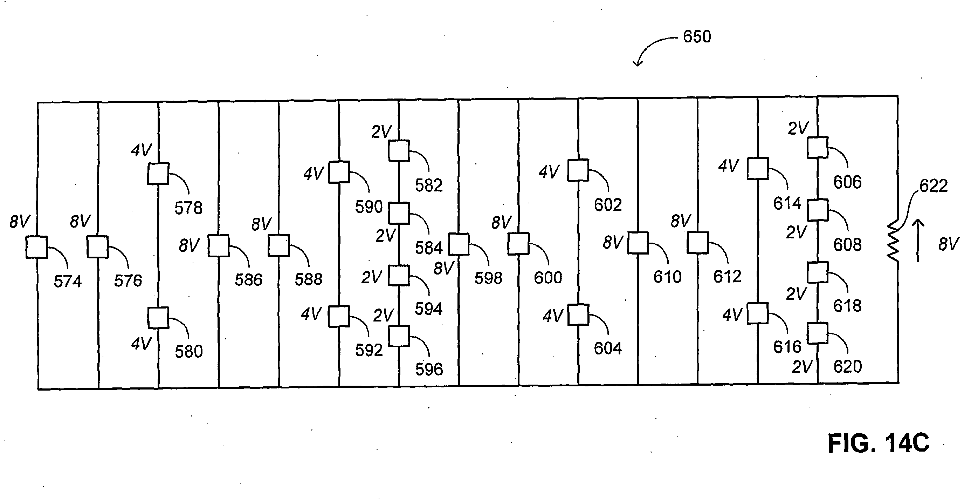

Reference is now made to Figures 14A, 14B and 14C. Figure 14A is a schematic illustration of a plurality of cells embedded in a cell array, generally referenced 570, constructed and operative in accordance with another embodiment of the disclosed technique. Figure 14B is a schematic illustration of the four quadrants of a circle, generally referenced 572. Figure 14C is a schematic illustration of a circuit, generally referenced 650, in which the groups and the sub-groups of Figure 14A are coupled with a load.

Cell array 570 is round, however the cell array can be manufactured in a polygonal shape, such as hexagon, square, and the like. Cell array 570 is divided to four quadrants I, II, III and IV, as illustrated in circle 572 of Figure 14B. Quadrant I of cell array 570 includes groups 574 and 576, and sub-groups 578, 580, 582 and 584. Quadrant II of cell array 570 includes groups 586 and 588, and sub-groups 590, 592, 594 and 596. Quadrant III of cell array 570 includes groups 598 and 600, and sub-groups 602, 604, 606 and 608. Quadrant IV of cell array 570 includes groups 610 and 612, and sub-groups 614, 616, 618 and 620. The boundaries of the groups and the sub-groups in Figure 14A are indicated by thick lines, whereas the boundaries of the cells in each group and sub-group are designated by broken lines.

Group 574 includes cells $574_1$, $574_2$, $574_3$, $574_4$, $574_5$, $574_6$, $574_7$ and $574_8$. Group 576 includes cells $576_1$, $576_2$, $576_3$, $576_4$, $576_5$, $576_6$, $576_7$ and $576_8$. Sub-group 578 includes cells $578_1$, $578_2$, $578_3$ and $578_4$. Sub-group 580 includes cells $580_1$, $580_2$, $580_3$ and $580_4$. Sub-Group 582 includes cells $582_1$ and $582_2$. Sub-group 584 includes cells $584_1$ and $584_2$.

Group 586 includes cells $586_1$, $586_2$, $586_3$, $586_4$, $586_5$, $586_6$, $586_7$ and $586_8$. Group 588 includes cells $588_1$, $588_2$, $588_3$, $588_4$, $588_5$, $588_6$, $588_7$ and $588_8$. Sub-group 590 includes cells $590_1$, $590_2$, $590_3$ and $590_4$. Sub-group 592 includes cells $592_1$, $592_2$, $592_3$ and $592_4$. Sub-group 594 includes cells $594_1$ and $594_2$. Sub-group 596 includes cells $596_1$ and $596_2$.

The number of cells included in each of the groups 598 and 600, and each of the sub-groups 602, 604, 606 and 608, is equal to the number of cells included in each of the groups 574 and 576, and each of the sub-groups 578, 580, 582 and 584, respectively. The number of cells included in each of the groups 610 and 612, and each of the sub-groups 614, 616, 618 and 620, is equal to the number of cells included in each of the groups 574 and 576, and each of the sub-groups 578, 580, 582 and 584, respectively.

Cells $574_1$, $574_2$, $574_3$, $574_4$, $574_5$, $574_6$, $574_7$ and $574_8$ are coupled together in series. Cells $576_1$, $576_2$, $576_3$, $576_4$, $576_5$, $576_6$, $576_7$ and $576_8$ are coupled together in series. Cells $578_1$, $578_2$, $578_3$ and $578_4$ are coupled together in series. Cells $580_1$, $580_2$, $580_3$ and $580_4$ are coupled together in series. Cells $582_1$ and $582_2$ are coupled together in series. Cells $584_1$ and $584_2$ are coupled together in series.

Cells $586_1$, $586_2$, $586_3$, $586_4$, $586_5$, $586_6$, $586_7$ and $586_8$ are coupled together in series. Cells $588_1$, $588_2$, $588_3$, $588_4$, $588_5$, $588_6$, $588_7$ and $588_8$ are coupled together in series. Cells $590_1$, $590_2$, $590_3$ and $5904$ are coupled together in series. Cells $592_1$, $592_2$, $592_3$ and $592_4$ are coupled together in series. Cells $594_1$ and $594_2$ are coupled together in series. Cells $596_1$ and $596_2$ are coupled together in series.

The couplings between the cells in each of the groups 598 and 600, and in each of the sub-groups 602, 604, 606 and 608, are similar to the couplings between the cells in each of the groups 574 and 576, and in each of the sub-groups 578, 580, 582 and 584, respectively. The couplings between the cells in each of the groups 610 and 612, and in each of the sub-groups 614, 616, 618 and 620, are similar to the couplings between the cells in each of the groups 574 and 576, and in each of the sub-groups 578, 580, 582 and 584, respectively.

The cells in cell array 570 are divided to groups and sub-groups, as described herein above. The boundaries of each group or each sub-group, define an area on cell array 570, which is exposed to light of an approximately uniform flux. Thus; all the cells included in a group or in a sub-group, are exposed to light of substantially the same flux, and the output current of these cells is substantially the same. For example, groups 574, 586, 598 and 610 are located in a region within cell array 570, which is illuminated by light of substantially the same flux. Thus, each of the cells $574_1$, $574_2$, $574_3$, $574_4$, $574_5$, $574_6$, $574_7$, $574_8$, $586_1$, $586_2$, $586_3$, $586_4$, $586_5$, $586_6$, $586_7$ and $586_8$, and each of the cells included in groups 598 and 610, produces substantially the same current. Groups 576, 588, 600 and 612 are exposed to light of substantially the same flux. Sub-groups 578, 580, 590, 592, 602, 604, 614 and 616 are exposed to light of substantially the same flux. Sub-groups 582, 584, 594, 596, 606, 608, 618 and 620 are exposed to light of substantially the same flux.

All the cells embedded in cell array 570 are exposed to light of the same wavelength. Therefore, the electric potential across the cells is substantially the same, and each cell produces a voltage V.

The following description pertains to quadrants I and II of cell array 570. Since the cells in each of the sub-groups 582, 584, 594 and 596 are coupled together in series, each of the groups 582, 584, 594 and 596 produces a voltage 2V. Sub-groups 582, 584, 594 and 596 are coupled together in series. Thus, the electrical potential across the serially coupled cells of sub-groups 582, 584, 594 and 596 is 8V.

Since the cells in each of the sub-groups 578 and 580 are coupled together in series, each of the sub-groups 578 and 580 produces a voltage 4V. Sub-groups 578 and 580 are coupled together in series. Thus, the electrical potential across the serially coupled cells of sub-groups 578 and 580 is 8V.

Since the cells in each of the sub-groups 590 and 592 are coupled together in series, each of the sub-groups 590 and 592 produces a voltage 4V. Sub-groups 590 and 592 are coupled together in series. Thus, the electrical potential across the serially coupled cells of sub-groups 590 and 592 is 8V. Each of the groups 574, 576, 586 and 588 includes eight cells, each cell produces a voltage of V and the cells are coupled together in series. Thus, the electrical potential across the serially coupled cells of each of the groups 574, 576, 586 and 588 is 8V.

The following description pertains to quadrants III and IV of cell array 570, and it is similar to the description concerning quadrants I and II herein above. Sub-groups 606, 608, 618 and 620 are coupled together in series. Sub-groups 602 and 604 are coupled together in series. Sub-groups 614 and 616 are coupled together in series. The electrical potential across the serially coupled cells of sub-groups 606, 608, 618 and 620 is 8V. The electrical potential across the serially coupled cells of sub-groups 602 and 604 is 8V. The electrical potential across the serially coupled cells of sub-groups 614 and 616 is 8V. Since each of the groups 598, 600, 610 and 612 includes eight cells, the electric potential across the serially coupled cells of each of the groups 598, 600, 610 and 612 is 8V. It is noted that division of cell array 570 into groups of cells, and the couplings between the cells in each group, is not limited to the example set forth in Figure 14A, and that other divisions and other couplings are possible.

With reference to Figure 14C, the four serially coupled sub-groups 582, 584, 594 and 596, the four serially coupled sub-groups 606, 608, 618 and 620, and each pair of serially coupled sub-groups 578 and 580, 590 and 592, 602 and 604, and 614 and 616, are coupled in parallel to groups 574, 576, 586, 588, 598, 600, 610 and 612, and to a load 622. Hence, the voltage across load 622 is 8V and the current flowing through a load 622 can be calculated by analyzing circuit 650.

By dividing the cells of cell array 570 into groups and sub-groups, and coupling together the groups and the sub-groups as in circuit 650, the cells which produce the same current are grouped together. Thus, the influence of a low-current-producing cell in restricting the current flowing through load 622, to the current produced by the low-current-producing cell, is substantially minimized. It is noted that circuit 650 is not unique to the disclosed technique, and that the cells embedded in cell array 570 can be coupled together according to other circuits known in the art.

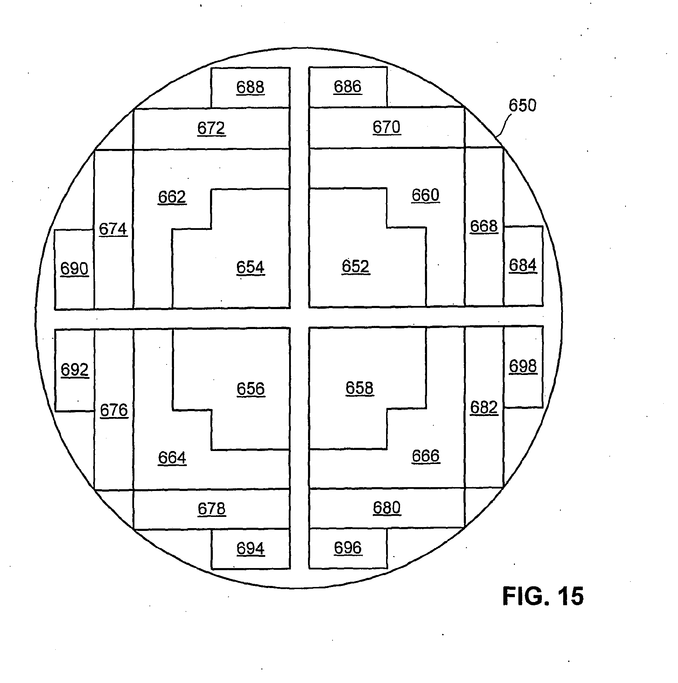

Reference is now made to Figure 15, which is a schematic illustration of a plurality of groups and sub-groups in a cell array, generally referenced 650, constructed and operative in accordance with a further embodiment of the disclosed technique. The cells (not shown) embedded in cell array 650 are divided to the following groups and sub-groups: 652, 654, 456, 658, 660, 662, 664, 666, 668, 670, 672, 674, 676, 678, 680, 682, 684, 686, 688, 690, 692, 694, 696 and 698.

Each of the groups 652, 654, 656 and 658 is exposed to light of substantially the same flux. Each of the groups 660, 662, 664 and 666 is exposed to light of substantially the same flux. Each of the sub-groups 668, 670, 672, 674, 676, 678, 680 and 682 is exposed to light of substantially the same flux. Each of the sub-groups 684, 686, 688, 690, 692, 694, 696 and 698 is exposed to light of substantially the same flux.

It will be appreciated by persons skilled in the art that the disclosed technique is not limited to what has been particularly shown and described hereinabove. Rather the scope of the disclosed technique is defined only by the claims, which follow.

**Claims**

1. A method for soldering at least one substantially large terminal of a high power electrical component to a substantially large area contact surface (104), the method comprising the procedures of:

   depositing soldering material on said substantially large area contact surface according to a protruding pattern, said protruding pattern defining a plurality of passages leading toward the perimeter of said substantially large contact surface;

placing said at least one substantially large terminal (112, 114, 116) on said deposited soldering material (118), the area of said at least one terminal substantially overlapping with a portion of said substantially large area contact surface; and

heating said at least one substantially large terminal, said soldering material and said substantially large area contact surface, according to a predetermined heating profile, said passages providing discharge of gas entrapped between said soldering material and said at least one substantially large terminal, toward said perimeter, to produce a substantially void free solid soldering material.

2. The method according to claim 1, further comprising prior to said procedure of depositing said soldering material, the procedure of placing a flow limiter on said substantially large area contact surface, between two portions of said substantially large area contact surface which exhibit different flow potentials.

3. The method according to claim 1, further comprising the procedure of clearing said soldering material remnants from said substantially large area contact surface, after said procedure of heating.

4. The method according to claim 1, wherein said high power electrical component is a photovoltaic cell.

5. The method according to claim 1, wherein said high power electrical component is an active antenna.

6. The method according to claim 1, wherein said high power electrical component is a microwave monolithic integrated circuit.

7. The method according to claim 1, wherein said substantially large area contact surface is electrically conductive.

8. The method according to claim 1, wherein said substantially large area contact surface is thermally conductive.

9. The method according to claim 1, wherein said protruding pattern is determined according to a solder paste stencil placed on said substantially large area contact surface, and
wherein said soldering material is deposited through said solder paste stencil.

10. The method according to claim 1, wherein said soldering material is deposited on said substantially large area contact surface with a plurality of injectors, for producing said protruding pattern.

11. The method according to claim 1, wherein said predetermined heating profile includes successively heating said substantially large area terminal, said deposited soldering material and said substantially large area contact surface at a plurality of temperatures, for a determined time period at each one of said temperatures.

12. A high power high thermally conductive platform comprising:

a substrate (102)
at least one substantially large area contact surface coupled with said substrate; and
a high power electrical component (338), including at least one substantially large area terminal, said at least one substantially large area terminal being soldered to said substantially large area contact surface,
wherein said high power electrical component is soldered to said substantially large area contact surface by depositing soldering material on said substantially large area contact surface, according to a protruding pattern, said protruding pattern defining a plurality of passages leading toward a perimeter of said substantially large area contact surface, by placing said at least one substantially large area terminal on said soldering material, an area of said at least one substantially large area terminal substantially overlapping with a portion of said substantially large area contact surface, by heating said substantially large area terminal, said soldering material and said substantially large area contact surface, according to a predetermined heating profile, and
wherein gas entrapped in said soldering material discharges away from said substantially large area contact surface, through said passages, to produce a substantially void free solid soldering material.

13. The platform according to claim 12 wherein at least one flow limiter is placed on said substantially large area contact surface between two portions of said substantially large area contact surface which exhibit different flow potentials.

14. The platform according to claim 12, wherein remnants of said soldering material are cleared from said substantially large area contact surface, where said soldering material is deposited.

15. The platform according to claim 12, wherein said high power electrical component is a photovoltaic cell.

16. The platform according to claim 12, wherein said high power electrical component is an active antenna.

17. The platform according to claim 12, wherein said high power electrical component is a microwave monolithic integrated circuit.

18. The platform according to claim 12, wherein said substantially large area contact surface is electrically conductive.

19. The platform according to claim 12, wherein said substantially large area contact surface is thermally conductive.

20. The platform according to claim 12, wherein said protruding pattern is determined according to a solder paste stencil placed on said substantially large area conducting surface, and
wherein said soldering material is deposited through said solder paste stencil.

21. The platform according to claim 12, wherein said soldering material is deposited on said substantially large area contact surface with a plurality of injectors, to produce said protruding pattern.

22. The platform according to claim 12, wherein said predetermined heating profile includes successively heating said substantially large area terminal, said soldering material and said substantially large area contact surface at a plurality of temperatures, for a determined time period at each one of said temperatures.

23. The platform according to claim 12, further comprising a cooling compartment coupled with said substrate for carrying away heat generated by said high power electrical component.

24. The platform according to claim 23, further comprising another substrate coupled with an opposite surface of said cooling compartment for providing thermal load balance.

25. The platform according to claim 23, further comprising at least one pin, coupled with said at least one substantially large area contact surface, for coupling said at least one substantially large area contact surface with an external electrical module.

26. The platform according to claim 25, wherein said substrate is provided with at least one hole for providing a passage for said at least one pin, from said substantially large area contact surface, through said cooling compartment, to said external electrical module.

27. The platform according to claim 25, wherein said cooling compartment is provided with at least one opening, to provide a passage for said at least one pin, from said substantially large area contact surface, to said external electrical module.

**Patentansprüche**

1. Verfahren zum Löten mindestens eines größeren Terminals eines elektrischen Hochleistungsbauteils an eine große Kontaktfläche (104), wobei das Verfahren aus folgenden Vorgängen besteht:

Auftragen von Lötmittel auf die besagte große Kontaktfläche nach einem vorspringenden Muster, das mehrere Rinnen bildet, die zum Perimeter der großen Kontaktfläche führen;
Aufbringung des mindestens einen Terminals (112, 114, 116) auf das aufgetragene Lötmittel (118), wobei die Fläche des mindestens einen Terminals im Wesentlichen einen Teil der großen Kontaktfläche überlappt; und
Erhitzen des mindestens einen größeren Terminals, des Lötmittels und der großen Kontaktfläche gemäß einem vorgegebenen Erhitzungsprofil, wobei die Rinnen dazu dienen, das zwischen dem Lötmittel und dem mindestens einen größeren Terminal eingeschlossene Gas zum Perimeter hin entweichen zu lassen, um ein im Wesentlichen blasenfreies Lötmittel zu erzeugen.

2. Verfahren gemäß Anspruch 1, weiterhin bestehend aus dem Vorgang, vor dem Auftragen des Lötmittels einen Durchflussbegrenzer auf die große Kontaktfläche zwischen zwei Bereichen der großen Kontaktfläche aufzubringen, welche verschiedene Potenzialströmungen aufweisen.

3. Verfahren gemäß Anspruch 1, weiterhin bestehend aus dem Vorgang, nach dem Erhitzen Reste des Lötmittels von der großen Kontaktfläche zu beseitigen.

4. Verfahren gemäß Anspruch 1, **dadurch gekennzeichnet, dass** das elektrische Hochleistungsbauteil eine photovoltaische Zelle darstellt.

5. Verfahren gemäß Anspruch 1, **dadurch gekennzeichnet, dass** das elektrische Hochleistungsbauteil eine aktive Antenne darstellt.

6. Verfahren gemäß Anspruch 1, **dadurch gekennzeichnet, dass** das elektrische Hochleistungsbauteil einen monolithisch integrierten Mikrowellenschaltkreis darstellt.

7. Verfahren gemäß Anspruch 1, **dadurch gekennzeichnet, dass** die große Kontaktfläche elektrisch leitend ist.

8. Verfahren gemäß Anspruch 1, **dadurch gekennzeichnet, dass** die große Kontaktfläche wärmeleitend ist.

9. Verfahren gemäß Anspruch 1, **dadurch gekennzeichnet, dass** das vorspringende Muster mit einem Lötpasten-Stencil auf die große Kontaktfläche vorgegeben wird, und
das Lötmittel mit dem Lötpasten-Stencil aufgetragen wird.

10. Verfahren gemäß Anspruch 1, **dadurch gekennzeichnet, dass** das Lötmittel mit mehreren Spritzen so auf die große Kontaktfläche aufgetragen wird, dass das besagte vorspringende Muster entsteht.

11. Verfahren gemäß Anspruch 1, **dadurch gekennzeichnet, dass** das vorgegebene Erhitzungsprofil so entsteht, dass das großflächige Terminal, das aufgetragene Lötmittel und die große Kontaktfläche nacheinander auf eine jeweils vorgegebene Zeit auf mehrere Temperaturen erhitzt werden.

12. Stark wärmeleitende Hochleistungsplattform bestehend aus einem Substrat (102),
mindestens einer mit dem Substrat gekoppelten großen Kontaktfläche; und
einem elektrischen Hochleistungsbauteil (338) einschließlich mindestens einem großflächigen Terminal, wobei das mindestens eine großflächige Terminal an eine große Kontaktfläche angelötet wird,
**dadurch gekennzeichnet, dass** das elektrische Hochleistungsbauteil an die große Kontaktfläche angelötet wird, indem Lötmittel gemäß einem vorspringenden Muster auf die große Kontaktfläche aufgebracht wird, wobei das vorspringende
Muster mehrere Rinnen aufweist, die zu einem Perimeter der großen Kontaktfläche führen, indem das mindestens eine großflächige Terminal am Lötmittel angebracht wird, wobei eine Fläche des großflächigen Terminals im Wesentlichen einen Teil der großen Kontaktfläche überlappt, durch Erhitzen des großflächigen Terminals, des Lötmittels und der großen Kontaktfläche gemäß einem vorgegebenen Erhitzungsprofil, und dass das im Lötmittel eingeschlossene Gas durch die Rillen aus der großen Kontaktfläche entweichen kann, wobei ein im Wesentlichen blasenfreies Lötmittel erzeugt wird.

13. Plattform gemäß Anspruch 12, **dadurch gekennzeichnet, dass** mindestens ein Durchflussbegrenzer auf die große Kontaktfläche zwischen zwei Bereichen der großen Kontaktfläche aufgebracht ist, welche verschiedene Potenzialströmungen aufweisen.

14. Plattform gemäß Anspruch 12, **dadurch gekennzeichnet, dass** Reste des Lötmittels von der großen Kontaktfläche beseitigt werden, wo das Lötmittel aufgetragen wurde.

15. Plattform gemäß Anspruch 12, **dadurch gekennzeichnet, dass** das elektrische Hochleistungsbauteil eine photovoltaische Zelle darstellt.

16. Plattform gemäß Anspruch 12, **dadurch gekennzeichnet, dass** das elektrische Hochleistungsbauteil eine aktive Antenne darstellt.

17. Plattform gemäß Anspruch 12, **dadurch gekennzeichnet, dass** das elektrische Hochleistungsbauteil einen monolithisch integrierten Mikrowellenschaltkreis darstellt.

**18.** Plattform gemäß Anspruch 12, **dadurch gekennzeichnet, dass** die große Kontaktfläche elektrisch leitend ist.

**19.** Plattform gemäß Anspruch 12, **dadurch gekennzeichnet, dass** die große Kontaktfläche wärmeleitend ist.

**20.** Plattform gemäß Anspruch 12, **dadurch gekennzeichnet, dass** das vorspringende Muster mit einem Lötpasten-Stencil auf die große Kontaktfläche vorgegeben wird, und
das Lötmittel mit dem Lötpasten-Stencil aufgetragen wird.

**21.** Plattform gemäß Anspruch 12, **dadurch gekennzeichnet, dass** das Lötmittel mit mehreren Spritzen so auf die große Kontaktfläche aufgetragen wird, dass das besagte vorspringende Muster entsteht.

**22.** Plattform gemäß Anspruch 12, **dadurch gekennzeichnet, dass** das vorgegebene Erhitzungsprofil so entsteht, dass das großflächige Terminal, das aufgetragene Lötmittel und die große Kontaktfläche nacheinander auf eine jeweils vorgegebene Zeit auf mehrere Temperaturen erhitzt werden.

**23.** Plattform gemäß Anspruch 12, **dadurch gekennzeichnet, dass** sie weiterhin eine mit dem Substrat gekoppelte Kühlkammer aufweist, um die von dem elektrischen Hochleistungsbauteil erzeugte Wärme abzuleiten.

**24.** Plattform gemäß Anspruch 23, **dadurch gekennzeichnet, dass** sie weiterhin ein anderes Substrat enthält, das mit einer entgegengesetzten Oberfläche der Kühlkammer gekoppelt ist, um eine gleichmäßige Wärmebelastung herzustellen.

**25.** Plattform gemäß Anspruch 23, **dadurch gekennzeichnet, dass** sie weiterhin mindestens einen mit der mindestens einen großen Kontaktfläche gekoppelten Stift aufweist, der dazu dient, die mindestens eine große Kontaktfläche mit einem externen elektrischen Modul zu koppeln.

**26.** Plattform gemäß Anspruch 25, **dadurch gekennzeichnet, dass** das Substrat mindestens eine Öffnung aufweist, durch die der mindestens eine Stift von der großen Kontaktfläche durch die Kühlkammer zum externen elektrischen Modul führen kann.

**27.** Plattform gemäß Anspruch 25, **dadurch gekennzeichnet, dass** die Kühlkammer mindestens eine Öffnung aufweist, durch die der mindestens eine Stift von der großen Kontaktfläche durch das externe elektrische Modul führen kann.

**Revendications**

**1.** Procédé de brasage d'au moins une borne sensiblement large d'un composant électrique à haute puissance sur une surface de contact sensiblement large (104), le procédé comprenant les procédures consistant à :

déposer le matériau de brasure sur ladite surface de contact sensiblement large selon un motif en relief, ledit motif en relief définissant une pluralité de passages conduisant au périmètre de ladite surface de contact sensiblement large ;
placer ladite au moins une borne sensiblement large (112, 114, 116) sur ledit matériau de brasure (118) déposé, l'aire de ladite au moins une borne sensiblement large recouvrant sensiblement une portion de la surface de contact sensiblement large ; et
chauffer ladite au moins une borne sensiblement large, ledit matériau de brasure et ladite surface de contact sensiblement large, selon un profil de chauffage prédéterminé, lesdits passages émettant une décharge de gaz piégé entre ledit matériau de brasure et ladite au moins une borne sensiblement large, vers ledit périmètre, pour produire un matériau de brasure solide sensiblement dépourvu de vide.

**2.** Procédé selon la revendication 1, comprenant en outre avant ladite procédure de dépôt dudit matériau de brasure, la procédure consistant à placer un limiteur de flux sur ladite surface de contact sensiblement large, entre deux portions de ladite surface de contact sensiblement large qui présentent des potentiels de flux différents.

**3.** Procédé selon la revendication 1, comprenant en outre la procédure consistant à enlever les restes dudit matériau de brasure de ladite surface de contact sensiblement large, après ladite procédure de chauffage.

4. Procédé selon la revendication 1, dans lequel ledit composant électrique à haute puissance est une pile photovoltaïque.

5. Procédé selon la revendication 1, dans lequel ledit composant électrique à haute puissance est une antenne active.

6. Procédé selon la revendication 1, dans lequel ledit composant électrique à haute puissance est un circuit intégré monolithique à micro-ondes.

7. Procédé selon la revendication 1, dans lequel ladite surface de contact sensiblement large est électriquement conductrice.

8. Procédé selon la revendication 1, dans lequel ladite surface de contact sensiblement large est thermiquement conductrice.

9. Procédé selon la revendication 1, dans lequel ledit motif en relief est déterminé selon un pochoir de pâte de brasure sur ladite surface de contact sensiblement large, et
dans lequel ledit matériau de brasure est déposé à travers ledit pochoir de pâte de brasure.

10. Procédé selon la revendication 1, dans lequel ledit matériau de brasure est déposé sur ladite surface de contact sensiblement large avec une pluralité d'injecteurs pour produire ledit motif en relief.

11. Procédé selon la revendication 1, dans lequel ledit profil de chauffage prédéterminé comprend le chauffage successif de ladite borne sensiblement large, dudit matériau de brasure déposé et de ladite surface de contact sensiblement large à une pluralité de températures, pendant une période de temps déterminée à chacune desdites températures.

12. Plate-forme à haute puissance et à haute conductivité thermique comprenant :

un substrat (102) ;
au moins une surface de contact sensiblement large couplée au dit substrat ; et
un composant électrique à haute puissance (338) comprenant au moins une borne sensiblement large, ladite au moins une borne sensiblement large étant brasée sur ladite surface de contact sensiblement large,
dans laquelle ledit composant électrique à haute puissance est brasé sur ladite surface de contact sensiblement large en déposant du matériau de brasure sur ladite surface de contact sensiblement large selon un motif en relief, ledit motif en relief définissant une pluralité de passages conduisant à un périmètre de ladite surface de contact sensiblement large, en plaçant ladite au moins une borne sensiblement large sur ledit matériau de brasure, une aire de ladite au moins une borne sensiblement large recouvrant sensiblement une portion de ladite surface de contact sensiblement large, en chauffant ladite borne sensiblement large, ledit matériau de brasure et ladite surface de contact sensiblement large, selon un profil de chauffage prédéterminé, et
dans laquelle du gaz piégé dans ledit matériau de brasure se décharge hors de ladite surface de contact sensiblement large, à travers lesdits passages, pour produire un matériau de brasure solide sensiblement dépourvu de vide.

13. Plate-forme selon la revendication 12, dans laquelle au moins un limiteur de flux est placé sur ladite surface de contact sensiblement large entre deux portions de ladite surface de contact sensiblement large qui présentent des potentiels de flux différents.

14. Plate-forme selon la revendication 12, dans laquelle les restes dudit matériau de brasure sont enlevés de ladite surface de contact sensiblement large, où ledit matériau de brasure est déposé.

15. Plate-forme selon la revendication 12, dans laquelle ledit composant électrique à haute puissance est une pile photovoltaïque.

16. Plate-forme selon la revendication 12, dans laquelle ledit composant électrique à haute puissance est une antenne active.

17. Plate-forme selon la revendication 12, dans laquelle ledit composant électrique à haute puissance est un circuit intégré monolithique à micro-ondes.

**18.** Plate-forme selon la revendication 12, dans laquelle ladite surface de contact sensiblement large est électriquement conductrice.

**19.** Plate-forme selon la revendication 12, dans laquelle ladite surface de contact sensiblement large est thermiquement conductrice.

**20.** Plate-forme selon la revendication 12, dans laquelle ledit motif en relief est déterminé selon un pochoir de pâte de brasure placé sur ladite surface de contact sensiblement large, et
dans laquelle ledit matériau de brasure est déposé à travers ledit pochoir de pâte de brasure.

**21.** Plate-forme selon la revendication 12, dans laquelle ledit matériau de brasure est déposé sur ladite surface de contact sensiblement large avec une pluralité d'injecteurs pour produire ledit motif en relief.

**22.** Plate-forme selon la revendication 12, dans laquelle ledit profil de chauffage prédéterminé comprend le chauffage successif de ladite borne sensiblement large, dudit matériau de brasure et de ladite surface de contact sensiblement large à une pluralité de températures, pendant une période de temps déterminée à chacune desdites températures.

**23.** Plate-forme selon la revendication 12, comprenant en outre un compartiment de refroidissement couplé au dit substrat pour refouler la chaleur générée par ledit composant électrique à haute puissance.

**24.** Plate-forme selon la revendication 23, comprenant en outre un autre substrat couplé à une surface opposée dudit compartiment de refroidissement pour fournir un équilibre de charge thermique.

**25.** Plate-forme selon la revendication 23, comprenant en outre au moins une broche couplée à ladite au moins une surface de contact sensiblement large pour coupler ladite au moins une surface de contact sensiblement large à un module électrique externe.

**26.** Plate-forme selon la revendication 25, dans lequel ledit substrat est fourni avec au moins un trou pour fournir un passage pour ladite au moins une broche, de ladite surface de contact sensiblement large, à travers ledit compartiment de refroidissement, jusqu'au dit module électrique externe.

**27.** Plate-forme selon la revendication 25, dans lequel ledit compartiment de refroidissement est fourni avec au moins une ouverture, pour fournir un passage pour ladite au moins une broche, de ladite surface de contact sensiblement large au dit module électrique externe.

FIG. 1A

FIG. 1B

FIG. 2

EP 2 005 487 B1

210

212

214

214

214

212

**FIG. 3**

240

242

244

242

244

242

**FIG. 4**

272

270

272

274

274

**FIG. 5**

304

304

302

300

302

**FIG. 6**

FIG. 7

**FIG. 8A**

**FIG. 8B**

**FIG. 8C**

EP 2 005 487 B1

PLACING A PLURALITY OF FLOW LIMITERS ON A SUBSTANTIALLY LARGE AREA CONTACT SURFACE, BETWEEN TWO PORTIONS WHICH EXHIBIT DIFFERENT FLOW POTENTIALS  370

DEPOSITING SOLDERING MATERIAL ON THE CONTACT SURFACE, ACCORDING TO A PROTRUDING PATTERN, THE PROTRUDING PATTERN DEFINING A PLURALITY OF PASSAGES, LEADING TOWARD THE PERIMETER OF THE CONTACT SURFACE  372

PLACING AT LEAST ONE SUBSTANTIALLY LARGE AREA TERMINAL OF A HIGH POWER ELECTRICAL COMPONENT ON THE DEPOSITED SOLDERING MATERIAL, THE AREA OF THE TERMINAL SUBSTANTIALLY OVERLAPPING WITH A PORTION OF THE CONTACT SURFACE  374

HEATING THE TERMINAL, THE SOLDERING MATERIAL AND THE CONTACT SURFACE, ACCORDING TO A PREDETERMINED HEATING PROFILE, WHEREIN GAS ENTRAPPED BETWEEN THE SOLDERING MATERIAL AND THE TERMINAL, DISCHARGES AWAY THROUGH THE PASSAGES, WHICH ARE GRADUALLY FILLED WITH THE SOLDERING MATERIAL, THEREBY SOLDERING THE ELECTRICAL COMPONENT TO CONTACT SURFACE, WITH SUBSTANTIALLY VOID FREE SOLDERING MATERIAL  376

CLEARING SOLDERING MATERIAL REMNANTS FROM THE CONTACT SURFACE  378

**FIG. 9**

EP 2 005 487 B1

**FIG. 10A**

**FIG. 10B**

**FIG. 10C**

FIG. 11A

FIG. 11B

EP 2 005 487 B1

FIG. 12

FIG. 13

FIG. 14B

FIG. 14A

EP 2 005 487 B1

FIG. 14C

EP 2 005 487 B1

FIG. 15

EP 2 005 487 B1

**EP 2 005 487 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6906253 B2, Bauman
- EP 1298726 A
- US 6048656 A, Akram
- US 6881671 B2, Jensen
- US 6121689 A, Capote
- WO 9524058 A